# EUROPÄISCHE PATENTSCHRIFT

(11) **EP 0 361 212 B1**
(45) Veröffentlichungstag und Bekanntmachung des Hinweises auf die Patenterteilung: **15.12.1993**
(21) Anmeldenummer: 89116977.3
(22) Anmeldetag: 13.09.1989
(51) Int. Cl.: H03K 17/08

(54) **Schutzschaltung für einen Schalttransistor**
Protection circuit for a switching transistor
Circuit de protection pour un transistor de commutation

(30) Priorität: 28.09.1988 DE 3832918
(43) Veröffentlichungstag der Anmeldung: 04.04.1990
(73) Patentinhaber: SIEMENS AKTIENGESELLSCHAFT, 80333 München (DE)
(72) Erfinder: Hügel, Harald, Dipl.-Ing., D-8520 Erlangen (DE)

(56) Entgegenhaltungen:
- EP-A- 0 095 579
- DE-A- 2 555 509
- DE-A- 3 504 200
- ELEKTRONIK Heft 15, 1980, Seiten 45-49, DE; K.Rischmueller: "Pulsgesteuerte Treiberstufen für Brückenschaltungen"

## Beschreibung

Die Erfindung bezieht sich auf eine Schutzschaltung für einen Schalttransistor mit einer Abschalteinrichtung für ein Ansteuersignal des Schalttransistors, wobei die Abschalteinrichtung von einer den Schalttransistor überwachenden Kollektor-Emitter-Überwachung angesteuert wird.

Aus der Zeitschrift "Elektronik", 1980, Heft 25, Seiten 45 bis 49 ist eine Schutzschaltung für einen Schalttransistor mit einer Abschalteinrichtung für Ansteuerimpulse des Schalttransistors bekannt, wobei die Abschalteinrichtung von einem Komparator angesteuert wird, der eine Spannung am Schalttransistor mit einer Referenzspannung vergleicht und die Ansteuerimpulse bei Überlastung des Schalttransistors ausschaltet. Mit einer derartigen Schutzschaltung wird der Schalttransistor auf Entsättigung überwacht, d.h. es wird überprüft, ob eine Kollektor-Emitter-Spannung den bei gesättigtem Transistor auftretenden Wert übersteigt. Damit kann der Schalttransistor gegen Kurzschluß und Überlast geschützt werden. Bei der bekannten Schaltung wird also die an der Kollektor-Emitter-Strecke des Schalttransistors anstehende Spannung in einem Komparator mit einer dem Sättigungswert entsprechenden Referenzspannung verglichen und die Ansteuerimpulse werden abgeschaltet, wenn die Kollektor-Emitter-Spannung des Schalttransistors den Sättigungswert überschreitet.

Bei dieser Schaltung tritt jedoch folgendes Problem auf: Die Kollektor-Emitter-Spannung fällt beim Einschalten des Schalttransistors relativ langsam ab und erreicht den niedrigen statischen Wert erst nach einer gewissen Verzögerungszeit. Um zu verhindern, daß während dieser Verzögerungszeit die Schutzschaltung anspricht, muß diese eine entsprechende Verzögerung aufweisen. Da diese Verzögerung auch beim Schalten auf einen vorhandenen Kurzschluß wirksam ist, kann sich der Kurzschlußstrom in der Verzögerungszeit ungehindert aufbauen.

Ferner ist aus der DE-A-25 55 509 eine Schaltungsanordnung mit einem kurzschlußfesten Ausgang bekannt, wobei eine die Strombegrenzungsstufe des Ausgangstransistors bildende Diodenschaltung elektrisch parallel zu der Reihenschaltung der Basis-Emitter-Strecke des Ausgangstransistors und seines Emitterwiderstandes geschaltet ist. Die Diodenschaltung umfaßt eine Zenerdiode und die Emitter-Basis-Strecke eines Transistors. Dieser Transistor steuert einen monostabilen Multivibrator. Sobald ein Kurzschluß in der Last auftritt, steigt der über die Emitter-Kollektor-Strecke des Ausgangstransistors fließende Strom und der Spannungsabfall der Emitter-Basis-Strecke des Ausgangstransistors an. Beim Überschreiten des durch die Zenerdiode eingestellten Schwellwertes wird die Diodenschaltung leitend, der monostabile Multivibrator wird in seinem quasistabilen Zustand gesteuert und der Ausgangstransistor wird in seinen Sperrzustand geschaltet. Die Diodenschaltung bleibt solange leitend, bis der monostabile Multivibrator in seinen stabilen Zustand zurückgekippt ist. Mit dieser Schaltungsanordnung kann man nur den Strom des Ausgangstransistors im Falle eines Kurzschlusses begrenzen. Außerdem spricht die Schutzschaltung bedingt durch das vergleichende Mittel erst nach einer Ansprechverzögerung an.

Der Erfindung liegt nun die Aufgabe zugrunde, eine Schutzschaltung der eingangs genannten Art ohne Ansprechverzögerung auszubilden, wobei der Schalttransistor auch dann geschützt wird, wenn auf einen vorhandenen Kurzschluß geschaltet wird.

Diese Aufgabe wird erfindungsgemäß dadurch gelöst, daß eingangsseitig ein Zeitglied angeordnet ist, an dessen Eingang das Ansteuersignal ansteht, daß zur Basis-Emitter-Strecke des Schalttransistors eine Reihenschaltung aus einer Zener-Diode und einem Ausschalter elektrisch parallel geschaltet ist, daß das vom Ansteuersignal zeitverzögert ausgelöste Ausgangssignal des Zeitglieds einerseits den Ausschalter öffnet und gleichzeitig die Kollektor-Emitter-Überwachung aktiviert und daß mit dem Rücknehmen des Ansteuersignals der Auschalter sofort in seine Ruhelage zurückgesetzt wird.

Dadurch, daß die Basis-Emitter-Strecke des Schalttransistors mit einer abschaltbaren Zener-Diode versehen ist, wobei die Abschaltung frühestens erst nach Ablauf einer vorbestimmten Verzögerungszeit stattfindet, ist der Schalttransistor auch dann geschützt, wenn auf einen vorhandenen Kurzschluß geschaltet wird. Die Verzögerungszeit ist vom verwendeten Schalttransistor abhängig, da die Verzögerungszeit die Zeitspanne angibt, in der die Kollektor-Emitter-Spannung vom Einschaltzeitpunkt an gerechnet den niedrigen statischen Wert erreicht. Erst wenn der Schalttransistor diesen Betriebspunkt erreicht hat, wird die Kollektor-Emitter-Überwachung aktiviert und die Zener-Diode von der Basis-Emitter-Strecke des Schalttransistors abgeschaltet.

Mit Wechsel des Pegels des Ansteuersignals des Schalttransistors von "high" zu "low" springt der Ausschalter in seine Ruhelage, d.h. der Schalter ist geschlossen, und die Kollektor-Emitter- Überwachung wird nicht mehr angesteuert. Bei erneuter Ansteuerung des Schalttransistors wird der Basisstrom und dadurch der Kollektorstrom bzw. ein vorhandener Kurzschlußstrom durch die Zener-Diode während der Verzögerungszeit begrenzt. Durch das Zeitglied wird erst nach Ablauf der Verzögerungszeit der Ausschalter geöffnet nachdem die Kollektor-Emitter-Überwachung aktiviert wurde. Somit ist gewährleistet, daß auch beim Aufschalten auf einen vorhandenen Kurzschluß der Schalttransistor geschützt wird.

Zur weiteren Erläuterung der Erfindung wird auf die Zeichnung Bezug genommen, in der ein Ausführungsbeispiel einer Schutzschaltung für einen Schalttransistor nach der Erfindung schematisch veranschaulicht ist.
- FIG 1: zeigt eine erfindungsgemäße Schutzschaltung, in
- FIG 2: ist ein Ansteuersignal des Schalttransistors in einem Diagramm über der Zeit t dargestellt, in
- FIG 3: ist der Schaltzustand eines Ausschalters gemäß FIG 1 über der Zeit t in einem Diagramm dargestellt und die
- FIG 4: zeigt ein Ausgangssignal des Zeitgliedes, das in einem Diagramm über der Zeit t aufgetragen ist.

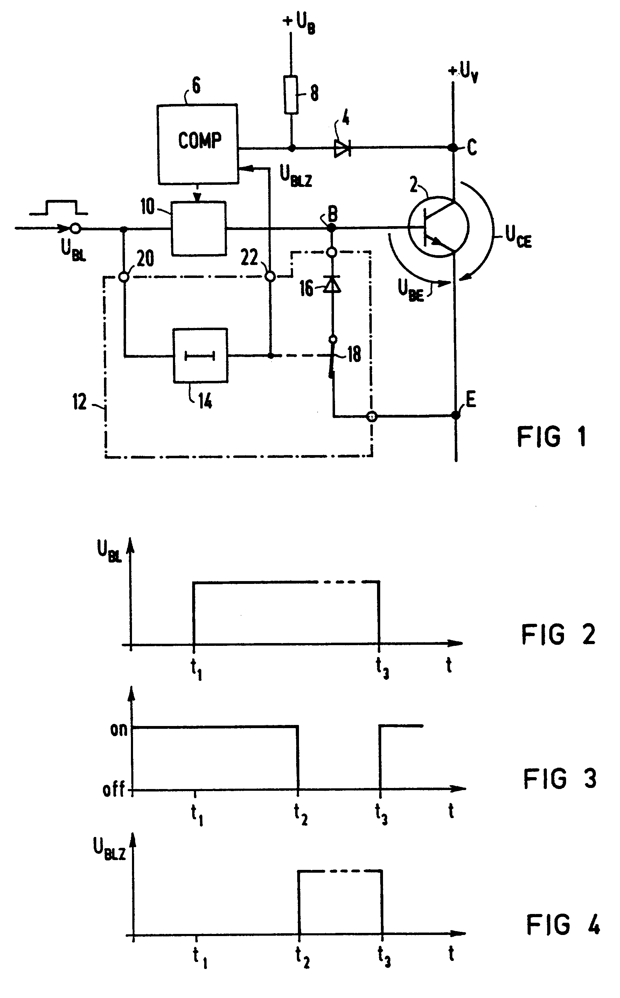

FIG 1 zeigt das schematisierte Grundschaltbild der erfindungsgemäßen Schutzschaltung. Dabei ist ein Schalttransistor 2 kollektorseitig an eine Versorgungsspannungsquelle +U_{V} angeschlossen. Dieser Schalttransistor 2 kann einer der beiden Schalttransistoren eines Brückenzweiges eines Stromrichters sein, wobei der Emitter E mit einem Kollektor des nachgeschalteten Schalttransistors, der aus Übersichtlichkeitsgründen nicht dargestellt ist, verbunden ist. Als Versorgungsspannung +U_{V} kann auch eine Spannung eines Zwischenkreises vorgesehen sein. Wenn der Schalttransistor 2 einer von beispielsweisen sechs Schalttransistoren eines Stromrichters ist, kann eine Last, die aus Übersichtlichkeitsgründen nicht dargestellt ist, am Kollektor C oder am Emitter E des Schalttransistors 2 angeschlossen sein. Außerdem ist über eine Entkopplungsdiode 4 der Kollektor C des Schalttransistors 2 mit einer Kollektor-Emitter-Überwachung 6 verknüpft, wobei die Anode der Entkopplungsdiode 4 über einen Widerstand 8 mit einer Versorgungsspannung +U_{B} verbunden ist. Der Basis B des Schalttransistors 2 werden Ansteuerimpulse U_{BL} über eine symbolisch dargestellte Abschalteinrichtung 10 zugeführt, mit der Einschaltimpulse für den Schalttransistor 2 im Störungsfall unterbrochen bzw. kurzgeschlossen werden können. Diese Abschalteinrichtung 10 wird von der Kollektor-Emitter-Überwachung 6 angesteuert. Außerdem wird das Ansteuersignal U_{BL} einer Schutzschaltung 12 zugeführt. Diese Schutzschaltung 12 enthält ein Zeitglied 14, eine Zener-Diode 16 und einen Ausschalter 18. Dabei ist das Zeitglied 14 einem Eingang 20 dieser Schutzschaltung 12 nachgeschaltet. Als Zeitglied 14 kann im einfachsten Fall ein Monoflop und als Zener-Diode 16 können auch mehrere elektrisch in Reihe geschaltete Dioden vorgesehen sein. Der Ausgang dieses Zeitgliedes 14 ist einerseits über einen Steuerausgang 22 mit der Kollektor-Emitter-Überwachung 6 und andererseits mit dem Ausschalter 18 verknüpft. Dieser Ausschalter 18 und die Zener-Diode 16 sind elektrisch in Reihe geschaltet, wobei diese Reihenschaltung elektrisch parallel zur Basis-Emitter-Strecke des Schalttransistors 2 geschaltet ist. Der Ausschalter 18 ist so konzipiert, daß wenn kein Ansteuersignal U_{BL} ansteht, der Schalter 18 in seiner Ruhelage sich befindet, d.h. der Schalter 18 ist geschlossen. Als Kollektor-Emitter-Überwachung 6 kann im einfachsten Falle ein Komparator vorgesehen sein, der die Kollektor-Emitter-Spannung U_{CE} des Schalttransistors 2 mit einer Referenzspannung vergleicht, wobei am Ausgang ein Signal ansteht, sobald diese Kollektor-Emitter-Spannung U_{CE} des Schalttransistors 2 größer ist als diese Referenzspannung.

Anhand der nachfolgenden FIG 2 bis 4 wird die Wirkungsweise dieser Schutzschaltung 12 nach FIG 1 näher erläutert.

In FIG 2 ist das Ansteuersignal U_{BL} in einem Diagramm über der Zeit t dargestellt. Die FIG 3 zeigt das Schaltschema des Ausschalters 18, wobei dieses Schaltschema in einem Diagramm über der Zeit t dargestellt ist. Außerdem zeigt die FIG 4 das Ausgangssignal U_{BLZ} des Zeitgliedes 14, wobei dieses Ausgangssignal U_{BLZ} in einem Diagramm über der Zeit t dargestellt ist. Zum Zeitpunkt t₁ steht an der Basis B des Schalttransistors 2 und am Eingang 20 der Schutzschaltung 12 das Ansteuersignal U_{BL} an. Gemäß FIG 4 erscheint am Ausgang des Zeitgliedes 14 noch kein Ausgangssignal U_{BLZ}, wodurch der Ausschalter 18 in seiner Ruhelage, d.h. er ist geschlossen, verharrt. Dadurch ist die Basis-Emitter-Strecke des Schalttransistors 2 durch die Reihenschaltung der Zener-Diode 16 und des Ausschalters 18 überbrückt. Durch das Ansteuersignal U_{BL} wird der Schalttransistor 2 angesteuert, wodurch ein Kollektorstrom zum Fließen kommt. Ist der Schalttransistor 2 auf einen vorhandenen Kurzschluß geschaltet worden, so wird der Kollektorstrom mit Hilfe der Zener-Diode 16 begrenzt. Zum Zeitpunkt t₂ erscheint am Ausgang des Zeitgliedes 14 ein Ausgangssignal U_{BLZ}, wodurch die Kollektor-Emitter-Überwachung 6 aktiviert wird und der Ausschalter 18 geöffnet wird. Die Zeitdifferenz t₂ - t₁ ist so bemessen, daß die Kollektor-Emitter-Spannung U_{CE} nach Einschalten auf seinen niedrigen statischen Wert abgesunken ist. Diese Zeitdifferenz ist vom verwendeten Schalttransistor 2 abhängig, wobei diese Zeitspanne in der Größenordnung von 15 bis 30 µsec. liegt. Nach Ablauf der Zeitdifferenz t₂ - t₁ wird einerseits der Ausschalter 18 im Ausschaltzustand gehalten und andererseits die Kollektor-Emitter-Überwachung 6 aktiv gehalten, solange an der Basis des Schalttransistors 2 und am Eingang 20 der Schutzschaltung 12 das Ansteuersignal U_{BL} sich im High-Zustand befindet. Zum Zeitpunkt t₃ geht der Pegel des Ansteuersignals U_{BL} vom High-Zustand in den Low-Zustand, wobei am Ausgang des Zeitgliedes 14 das Signal U_{BLZ} auch in den Low-Zustand wechselt. Dadurch, daß am Ausgang des Zeitgliedes 14 kein Signal U_{BLZ} mehr ansteht, springt der Ausschalter 18 sofort in seine Ruhelage zurück, d.h., daß die Zener-Diode 16 wieder parallel zur Basis-Emitter-Strecke des Schalttransistors 2 geschaltet ist. Somit ist der Schalttransistor 2 außerhalb der Aktivierungszeit der Kollektor-Emitter-Überwachung 6 durch die Zener-Diode 16 geschützt. Durch diese Zener-Diode 16 wird die Basis-Emitter-Spannung U_{BE} dieses Schalttransistors 2 begrenzt, wodurch bei Kurzschluß der Ansteuerstrom von der Basis in die Zener-Diode 16 fließt, sobald die Basis-Emitter-Spannung U_{BE} den Wert der Zener-Spannung erreicht hat. Dadurch wird bei Kurzschluß der Schalttransistor 2 schwach angesteuert, wodurch der Kurzschlußstrom bzw. der Kollektorstrom begrenzt wird. Da die Zener-Diode 16 ausgeschaltet wird, sobald die Kollektor-Emitter-Spannung U_{CE} des angesteuerten Schalttransistors 2 seinen Nennwert erreicht hat, kann kein Teil des Basisstromes über die Zener-Diode 16 mehr abfließen. Dadurch wird die natürliche Verstärkung des Schalttransistors 2 nicht verringert. Im Nennbetriebspunkt wird der Schalttransistor 2 mittels der Kollektor-Emitter-Überwachung 6 gegen Überlast geschützt.

## Patentansprüche

1. Schutzschaltung (12) für einen Schalttransistor (2) mit einer Abschalteinrichtung (10) für ein Ansteuersignal (U_{BL}) des Schalttransistors (2), wobei die Abschalteinrichtung (10) von einer den Schalttransistor (2) überwachenden Kollektor-Emitter-Überwachung (6) angesteuert wird, **dadurch gekennzeichnet,** daß eingangsseitig ein Zeitglied (14) angeordnet ist, an dessen Eingang (20) das Ansteuersignal (U_{BL}) ansteht, daß zur Basis-Emitter-Strecke des Schalttransistors (2) eine Reihenschaltung aus einer Zener-Diode (16) und einem Ausschalter (18) elektrisch parallel geschaltet ist, daß das vom Ansteuersignal (U_{BL}) zeitverzögert ausgelöste Ausgangssignal (U_{BLZ}) des Zeitglieds (14) einerseits den Ausschalter (18) öffnet und gleichzeitig die Kollektor-Emitter-Überwachung (6) aktiviert und daß mit dem Rücknehmen des Ansteuersignals (U_{BL}) der Ausschalter (18) sofort in seine Ruhelage zurückgesetzt wird.

## Claims

1. Protection circuit (12) for a switching transistor (2) having a switching-off device (10) for a control signal (U_{BL}) of the switching transistor (2), wherein the switching-off device (10) is controlled by a collector-emitter monitoring device (6) monitoring the switching transistor (2), characterised in that on the input-side there is arranged a timing element (14) at whose input (20) the control signal (U_{BL}) is applied, in that electrically connected in parallel with the base-emitter-path of the switching transistor (2) is a series circuit comprising a Zener diode (16) and an on-off switch (18), in that the output signal (U_{BLZ}) of the timing element (14), triggered in time-delayed manner, on the one hand opens the on-off switch (18) and at the same time activates the collector-emitter-monitoring device (6), and in that with the cancelling of the control signal (U_{BL}) the on-off switch (18) is immediately returned into its rest position.

## Revendications

1. Circuit de protection (12) pour un transistor de commutation (2) comportant un dispositif d'interruption (10) pour un signal de commande (U_{BL}) du transistor de commutation (2), le dispositif d'interruption (10) étant commandé par une unité de contrôle collecteur - émetteur (6) qui contrôle le transistor de commutation (2), caractérisé par le fait qu'il est prévu, côté entrée, un circuit de temporisation (14), à l'entrée (20) duquel est appliqué le signal de commande (U_{BL}), qu'un circuit série formé d'une diode Zener (16) et d'un interrupteur (18) est branché électriquement en parallèle avec la section base - émetteur du transistor de commutation (2), que le signal de sortie (U_{BLZ}) du circuit de temporisation (14), qui est déclenché d'une manière retardée par le signal de commande (U_{BL}), ouvre, d'une part, l'interrupteur (18) et active simultanément l'unité de contrôle collecteur - émetteur (6), et que lors de la suppression du signal de commande (U_{BL}), l'interrupteur (18) est immédiatement ramené dans sa position de repos.
